(19)

Europäisches Patentamt

European Patent Office

Office européen des brevets

(11) **EP 1 557 486 A1**

(12) **EUROPEAN PATENT APPLICATION**
published in accordance with Art. 158(3) EPC

(43) Date of publication:
27.07.2005 Bulletin 2005/30

(51) Int Cl.7: **C30B 29/22**, H01L 39/24

(21) Application number: 03769995.6

(22) Date of filing: **29.10.2003**

(86) International application number:
**PCT/JP2003/013888**

(87) International publication number:
**WO 2004/040047 (13.05.2004 Gazette 2004/20)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **31.10.2002 JP 2002318523**

(71) Applicants:
• **SUMITOMO ELECTRIC INDUSTRIES, Ltd**
**Osaka-shi, Osaka 541-0041 (JP)**
• **International Superconductivity Technology Center, The Juridical Foundation**
**Tokyo 105-0004 (JP)**

(72) Inventors:
• **HASEGAWA, Katsuya, c/o Osaka Works**
**Konohana-ku Osaka-shi Osaka 554-8511 (JP)**
• **IZUMI, Teruo,**
**c/o Superconductivity Research Lab.**
**Tokyo 135-0062 (JP)**

• **SHIOHARA, Yuh,**
**c/o Superconductivity Research Lab.**
**Tokyo 135-0062 (JP)**
• **SUGAWARA, Yoshihiro,**
**c/o Japan Fine Ceramics Ctr.**
**Nagoya-shi, Aichi 456-8587 (JP)**
• **HIRAYAMA, Tsukasa,**
**c/o Japan Fine Ceramics Center**
**Nagoya-shi, Aichi 456-8587 (JP)**
• **OBA, Fumiyasu,**
**Dpt Materials Science & Engineering**
**Kyoto-shi Kyoto 606-8501 (JP)**
• **IKUHARA, Yuichi, c/o The University of Tokyo**
**Tokyo 113-8656 (JP)**

(74) Representative: **Kreutzer, Ulrich, Dipl.-Phys. et al**
**Cabinet Beau de Loménie,**
**Bavariaring 26**
**80336 München (DE)**

(54) **SINGLE CRYSTAL BASE THIN FILM**

(57)     The invention relates to a technique for forming a single crystalline thin film of good quality on an underlayer. Such a technique is suitably applicable to provision of an oxide high-temperature superconductor thin film usable for a superconducting wire material, a superconducting device or the like.

The single crystalline thin film formed on a substratum is made of a substance different from that of the substratum. A specific atomic layer contained in common in the substratum and the thin film is shared at an interface between the substratum and the thin film. In a region as adjacent to the interface as 100 or fewer unit cells of the thin film apart from the interface, a ratio of crystalline region having grown with an orientation of ± 2 degrees or less deviation angle on the basis of a crystal orientation of the substratum is 50% or more.

FIG.2

**Description**

Technical Field

The present invention relates to a technique for forming a single crystalline thin film of good quality on an underlayer. Such a technique is preferably applicable to provision of an oxide high-temperature superconductor thin film usable, e.g., for a superconducting wire material or a superconducting device.

Background Art

Oxide high-temperature superconductors have been expected to be practically applied to superconducting electromagnets, superconducting cables, superconducting devices and others, because they have their critical temperatures higher than the liquid nitrogen temperature and do not require the very low temperature of liquid helium. Accordingly, various studies have been in progress for the oxide high-temperature superconductors.

For a using manner of an oxide high-temperature superconductor, a superconductor thin film has attracted attention, since it exhibits a high critical current density and can be made with a large area. To form an oxide high-temperature superconductor thin film, however, it is necessary to use an underlayer having sufficient strength for supporting the thin film. The high critical current density can be obtained only when a single crystalline thin film of oxide high-temperature superconductor is formed by epitaxial growth on such an underlayer. That is, it is important to select an underlayer suitable for epitaxial growth of the thin film thereon to ensure formation of an oxide high-temperature superconductor thin film exhibiting a high critical current density. Accordingly, it has been tried to use various underlayers for formation of various oxide high-temperature superconductor thin films thereon.

Herein, the underlayer generally refers to any substratum coming into contact with and thus forming an interface with an objective thin film. When the objective thin film is formed on a bulky base substance, the underlayer refers to the base substance. When the objective thin film is formed on a bulky base substance with an intermediate layer interposed therebetween, the intermediate layer corresponds to the underlayer.

There are many cases where a single crystalline thin film having properties similar to those of a bulky single crystal cannot be obtained when the objective thin film is formed on an underlayer made of a substance different from that of the crystalline thin film, because the underlayer affects the objective thin film when the thin film is formed thereon.

For example, in the case of the Y123 thin film having extensively been studied, the critical temperature Tc of zero resistance is often lower than 90 K, and cannot reach 92 K that is achieved with a bulky single crystal. Herein, RE123 represents $RE_{1+x}Ba_{2-x}Cu_3O_{7-y}$, where RE is at least one kind of rare earth elements such as Y, Nd and Sm. In the case of Nd123 which has in the bulk state the critical temperature Tc of 96 K higher than that of Y123, it is further difficult to obtain a high Tc in the thin film state. For Nd123, it is now still tried to seek formation conditions of a thin film achieving a high Tc. The film formation conditions currently considered are limited in a narrow range, and the highest possible Tc in the thin film state is about 93K much lower than the Tc obtainable in the bulk state.

Although the reasons why the oxide superconducting material shows a low Tc in the thin film state have not been identified yet, one conceivable factor is that a thin-film crystal grown on an underlayer by a non-equilibrium process includes a large number of defects, since the crystal has its crystal lattice suffering strain under constraint of the underlayer. It is considered that in reality this and other factors are combined together to cause the low Tc.

Disclosure of the Invention

In view of the above-described situations of the conventional art, an object of the present invention is, upon formation of an objective thin film on an underlayer, to enable formation of a single crystalline thin film of better quality to thereby provide a thin film having properties equal or superior to those of a bulky substance.

According to the present invention, in a single crystalline thin film formed on an underlayer, the thin film is made of a substance different from that of the underlayer, and a specific atomic layer contained in common in the underlayer and the thin film is shared at an interface of the underlayer and the thin film. In a region as adjacent to the interface as 100 or fewer unit cells of the thin film apart from the interface, a ratio of crystalline region having grown with an orientation of ± 2 degrees or less deviation angle on the basis of a crystal orientation of the underlayer is 50% or more.

It is desirable that each of the thin film and the underlayer is made of a substance having a stacked-layer crystal structure. Further, it is preferable that at least one of the thin film and the underlayer is made of an oxide including at least two kinds of metal elements.

Preferably, at least one of the thin film and the underlayer is made of a substance having a crystal structure of a perovskite type. A difference in lattice constant between the thin film and the underlayer is preferably in a range of more than 5% and less than 15%.

Preferably, the thin film is made of a $RE_{1+x}Ba_{2-x}Cu_3O_{7-y}$ based superconductor and the underlayer is made of $BaZrO_3$. The thin film can show superconductivity at a temperature of higher than 91 K.

Preferably, the interface has its interface energy of lower than 2 $J/m^2$. The interface energy can be calculated by the first-principles calculation band method.

Brief Description of the Drawings

Fig. 1 shows an actual electron micrograph of a lattice image at an interface of Sm123/BZO, with a simulation image inserted in a portion thereof.

Fig. 2 shows a lattice model of the interface of Sm123/BZO used for the image simulation.

Fig. 3 is a schematic diagram showing crystal orientations in an Sm123 film in the vicinity of an interface with a BZO underlayer.

Fig. 4 is a schematic diagram showing crystal orientations in an Sm123 film in the vicinity of an interface with an MgO underlayer.

Fig. 5 is a graph showing the relation between the thickness and the critical temperature Tc of the Sm123 film.

Fig. 6 is a graph showing the dependence of the resistance on the temperature in the Sm123 film.

Fig. 7 is a graph showing the relation between the thickness and the critical current density Jc of the Sm123 film.

Fig. 8 is a graph showing the dependence of the critical current density Jc on the external magnetic field B in the Sm 123 film.

Figs. 9A and 9B are lattice models of the interface of Sm123/MgO (in the case of Ba on Mg), showing the states before and after relaxation, respectively.

Figs. 10A and 10B are lattice models of the interface of Sm123/BZO, showing the states before and after relaxation, respectively.

Figs. 11A and 11B are graphs showing the amount of displacement from the atomic site of a perfect crystal, showing the case of the interface of Sm123/MgO (Ba on Mg) and the case of the interface of Sm123/BZO, respectively.

Best Modes for Carrying Out the Invention

The underlayer used in the present invention is a single crystalline substratum made of a substance different from that of an objective thin film to be epitaxially grown thereon, and forms an interface with the objective thin film. More specifically, the underlayer in the present invention may include a single crystalline bulky substance itself unprovided with a coating layer, a bulky substance coated with a single crystalline film, an intermediate layer epitaxially grown on a single crystalline bulky substance (or an oriented metal tape material), or an oriented intermediate layer on a non-oriented metal substrate.

As an embodiment of the present invention, explanation is given regarding an example of using as the underlayer a bulky substance coated with a single crystalline film which is formed with BZO film/MgO single crystal and forming Sm123 as the objective film thereon. Herein, BZO represents $BaZrO_3$.

The inventers have pointed out (see J. Japan Inst. Metals, Vol. 66 (2002), pp. 320-328) a possibility that at the interface of epitaxially grown Sm123/BZO, an atomic layer BaO contained in common in the substances on both sides of the interface may be shared by the substances, from their consideration of crystal structures of these substances. Further, the inventors have considered that, when the interface is formed of an atomic layer common to the substances on both sides thereof, the chemical factor of the interface energy would be reduced, leading to improved epitaxy. Such an atomic microstructure of the interface, however, has not been specified yet, and it is not yet expected what properties the objective film has.

For the thin film formed on the underlayer according to the present invention, high-resolution electron microscopy was employed for observation and analysis of the atomic structure at the interface, so that the interface structure was specified. It was also found from observation of a wider region of the structure that the observed film was a single crystalline thin film exhibiting favorable crystal orientation from the vicinity of the interface. Further, to consider how the interface structure affects the properties of the objective film, attention was paid to the distance from the interface, i.e., to the film thickness, and then dependence of the film properties on the film thickness was investigated.

Sm123/MgO in which the same atomic layer cannot be shared at the interface was adopted as a comparative example. The MgO is a single crystal substrate for use to epitaxially grow a BZO film thereon and is considered to be suitable for the comparative example in contrast to the present invention, since it has a lattice constant almost equal to that of BZO and it does not have an atomic layer common to any of Sm123 in view of the crystal structure.

Consequently, as explained in the present embodiment, requirements have been found for the thin film in which a specific atomic layer contained in common in a substance of the objective thin film and another substance of the underlayer is shared at the interface of the objective film and the underlayer, thereby realizing good properties as a single crystalline thin film having favorable crystal orientation from the vicinity of the interface.

It is understood that the principle described in the present embodiment is sufficiently applicable not only to the interface of Sm123/BZO but also to the interface of RE123/BZO where Sm123 is replaced with RE123-based high-temperature superconductor that also contains a BaO layer and has a crystal structure of a similar type. The BZO intermediate layer is not restricted to the one formed on a bulky single crystal of MgO. In expectation of realizing the effects of the present invention, it is also possible to use as the intermediate layer a BZO film formed on a MgO film that is deposited and in-plane oriented by "the tilted substrate method" (see Japanese Patent Laying-Open No. 7-291626) on a metal substrate of high strength such as hastelloy, as long as it has single crystalline properties. Further, it is understood that the present invention is an important technique widely applicable to general single crystalline thin films, since the invention has proved the above-described characteristic interface structure in which a specific atomic layer is shared at the interface regarding Sm123 of a complicated structure whose unit cell consists of six atomic layers, and confirmed favorable properties of the obtained thin film.

(Examples)

Sm123/BZO is adopted as an example of combination that can share a specific atomic layer at the interface, and explanation is given for experimental methods and results thereof. A BZO intermediate layer and Sm123 were formed on a MgO (100) single crystal substrate by laser deposition. The details of film formation conditions are similar to those as described in J. Japan Inst. Metals, Vo. 66, No. 4 (2002), pp. 320-328.

A comparative example is Sm123/MgO that cannot share a specific atomic layer at the interface. The sample was prepared in the similar manner as that of the example, except that the BZO intermediate layer was omitted.

High-resolution transmission electron microscopy was used for observation of the interface. For the above-described samples, processes preparing specimens for the transmission electron microscopy, such as cutting, lamination, processing of making a minute hole called dimpling, ion thinning and others were employed to obtain cross-sectional specimenes thin enough to allow observation of the vicinities of the Sm123/BZO interface and the Sm123/MgO interface.

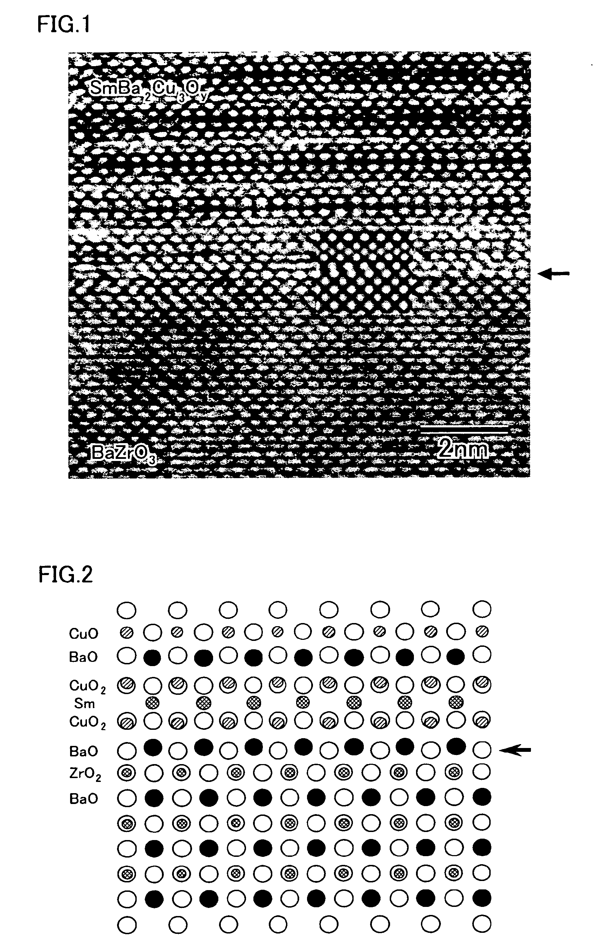

The electron micrograph of Fig. 1 shows a crystal lattice image in the vicinity of the observed interface of Sm123/BZO. It is shown that the Sm123 layer has its crystal highly oriented from the vicinity of the interface. An image simulation technique called a multi-slicing method was employed for analysis of the interface structure. The interface structure, i.e., the crystal structures of the two substances forming the interface and their lattice constants, and additionally, the order of stacking of the atomic layers at the interface and their geometric arrangement were put into a model as shown in Fig. 2. Then, parameters related to the observation conditions (including electronic optical condition and sample thickness) were varied in a computer to simulate a transmission electron microscopic image. The resulting simulation image is inserted as a computed image in the real image in Fig. 1 (see inside a square at the center to the right).

In Fig. 2, white circles represent oxygen atoms, and shaded circles represent metal atoms. A portion lower than a horizontal interface shown with an arrow represents atomic arrangement of the BZO crystal as seen in its <100> direction, and the other portion upper than the interface represents atomic arrangement of the Sm123 crystal as seen in its <100> direction. The BZO crystal includes BaO and $ZrO_2$ atomic layers. The Sm123 crystal includes Sm, BaO, $CuO_2$, and CuO atomic layers. That is, the BaO atomic layer is contained in common in the BZO crystal and the Sm123 crystal. In Fig. 2, the BZO and Sm123 crystals share the BaO atomic layer at the interface therebetween.

In calculation of the simulation image inserted in Fig. 1, electron beam was directed in a direction perpendicular to the paper plane of Fig. 2. That is, the incident direction of the electron beam is in parallel with the <100> direction of the BZO crystal and the <100> direction of the Sm123 crystal.

The real electron micrograph in Fig. 1 and the simulation image inserted therein have very similar lattice image patterns. This indicates that the atomic layers in the interface structure of the real specimen for the electron microscopy should be stacked in such a manner as shown in the model of Fig. 2 (the position of the arrow in Fig. 1 corresponds to the position of the arrow in Fig. 2). More specifically, the BaO layer at the interface is the BaO layer of the Sm123 crystal and at the same time the BaO layer of the BZO crystal, and thus it is proved that a specific atomic layer at the interface is shared by the substances on both sides thereof. It is noted that only the heavy metal atoms are seen in the electron micrograph of Fig. 1, with the light oxygen atoms unseen due to their small electron scattering power. The same applies to the simulation image.

Although a high-resolution electron microscopic image is not obtained for the Sm123/MgO interface of the comparative example, it is impossible that an atomic layer common to the two substances is shared at the interface because of their crystal structures. The reason is that there is no such atomic layer common to the Sm123 and MgO crystals. Further, in the case that a specific atomic layer can not be shared at the interface, it is unlikely that a specific one of the six atomic layers included in the S123 unit cell becomes a termination plane at the interface. As described in Physica C, Vol. 371 (2002), pp. 309-314, at the interface of Y123/MgO, the termination plane of Y123 has BaO, CuO and other layers mixed therein. This means that considerable variation in order of stacking, i.e., a large number of stacking faults exist in the vicinity of the interface, and thus it is not possible to obtain such a structure highly oriented in the atomic layer level from the vicinity of the interface as shown in Fig. 1.

Next, variation in orientation of the Sm123 crystal was observed using a transmission electron microscope, for a wider view field including the interface to a distance of greater than 0.1 μm therefrom, which is on the order of 100 times the unit cell of Sm123 (having a c-axis length of about 1.17 nm). At this time, the cross-sectional specimen was tilted up to about 20 degrees with respect to the electron beam, with the a or b axis of the Sm123 crystal as a tilting axis, to thereby emphasize the variation in orientation of the Sm123 crystal as contrast difference. As a result, it was found that Sm123/MgO include a greater number of crystal grains having their orientation rotated about the c axis in the vicinity of the interface, compared to the case of Sm123/BZO. More specifically, it was found that, compared to the Sm123 film grown on the BZO underlayer, the Sm123 film grown on the MgO underlayer has its crystal orientation disturbed in response to rotation about the c axis perpendicular to the film surface, and thus it has a lower ratio of crystal grains having epitaxially grown exactly taking over the lattice orientation of the underlayer.

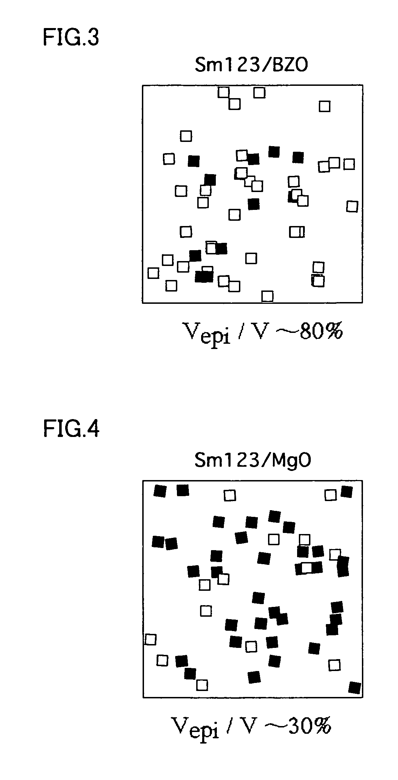

Figs. 3 and 4 are schematic plan views showing distribution in orientation of crystal grains in the vicinity of the interface of Sm123/BZO and in the vicinity of the interface of Sm123/MgO, respectively. In these figures, a mark □ represents the crystal grain having epitaxially grown with a deviation angle in a range of smaller than ± 2 degrees with respect to the lattice orientation of the underlayer, while a mark ■ represents the crystal grain with its lattice orientation having a deviation angle of greater than ± 2 degrees with respect to that of the underlayer. In Fig. 3, the ratio of volume $V_{epi}$ of the crystal grains epitaxially grown within the deviation angle range of smaller than ± 2 degrees to the total crystal grain volume V is about 80% more than 50%. In Fig. 4, on the other hand, the ratio of volume $V_{epi}$ of the crystal grains epitaxially grown within the deviation angle range of smaller than ± 2 degrees to the total crystal grain volume V is about 30% less than 50%.

It is conceivable that such a high ratio of more than 50% of the epitaxially grown Sm123 crystal grains in the case of Sm 123/BZO results from reduction in interface energy due to sharing of the BaO layer at the interface. By comparison, in the case of Sm123/MgO having no atomic layer that can be shared at the interface, even if the lattice orientation of Sm123 crystal coincides with the orientation of the underlayer, the interface energy would not be reduced to the degree as in the case of Sm123/BZO.

In relation to the interfaces of Sm123/BZO and Sm123/MgO, the Sm123 films on the respective interfaces were examined to compare their superconductivities. Specifically, the critical temperature Tc and the critical current density Jc with which resistance becomes zero were measured by a direct-current 4-terminal method. A magnetic field B (T: tesla) was applied parallel to the c axis of each Sm123 film. Since Sm123/BZO and Sm123/MgO have their interface structures quite different from each other as described above, properties of each of the Sm123 films were examined paying attention to the distance from the interface, i.e., the film thickness, and dependence of the film properties on the film thickness was analyzed.

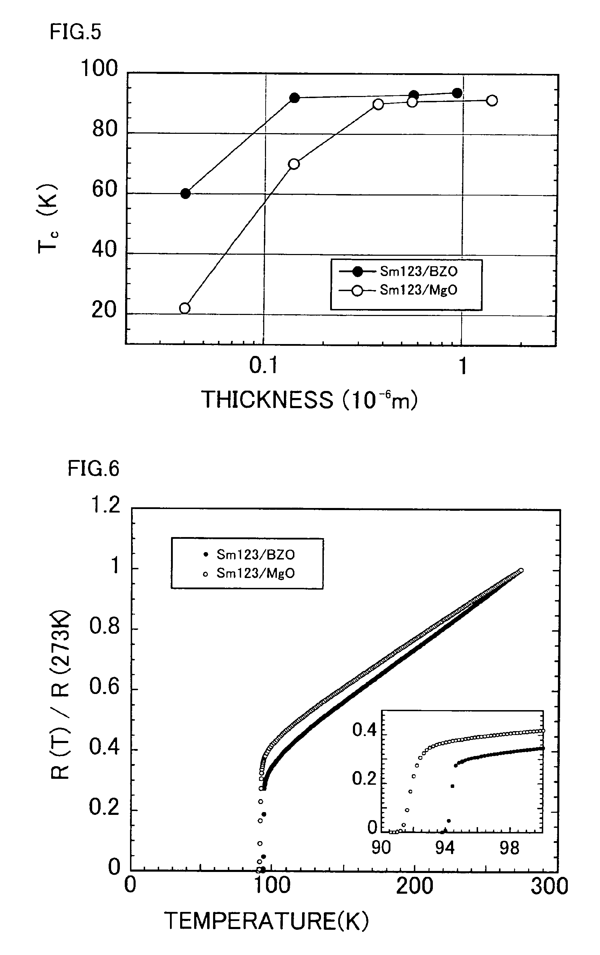

Fig. 5 shows the relation between the critical temperature Tc (K) causing zero resistance and the film thickness ($10^{-6}$ m) in each of the Sm123 films. It is seen that Tc of Sm123/BZO is considerably improved compared to that of Sm123/MgO in a region of the film thickness thinner than about 0.1 μm. The difference reaches 20 K to 40 K at the same film thicknesses. In any case, Tc is improved with increase of the film thickness, and it tends to be saturated at a film thickness exceeding a certain level. The film thickness causing such saturation is again thinner in Sm123/BZO than in Sm123/MgO. As such, it is found that favorable superconductivity is realized at the thinner film thickness or at a region closer to the interface in Sm123/BZO than in Sm123/MgO. This is presumably because the ratio of the epitaxially grown Sm123 crystal grains is greater than 50% in the case of Sm123/BZO, ensuring good continuity between the crystal grains.

Fig. 6 shows the dependence of the electric resistance on the temperature at the stage where Tc is saturated with increase of film thickness. In this graph, a horizontal axis represents the temperature (K), and a vertical axis represents the ratio of resistance R at a measurement temperature T (K) to resistance R at a constant temperature of 273 K. Further, a mark • and a mark o in the graph represent the resistance ratios for Sm123/BZO and SM123/MgO, respectively. A graph inserted in the graph of Fig. 6 is an enlarged version corresponding to the vicinity of the zero resistance region.

As shown in Fig. 6, Tc of Sm123/BZO is higher by about 3 K than that of Sm123/MgO, and reaches 93.8 K which is nearly equal to the value reported for a bulky single crystal of Sm123. In other words, according to the present invention, a high critical temperature Tc of zero resistance similar to that of a bulky single crystal is obtained in a thin film having a thickness of about 1 μm.

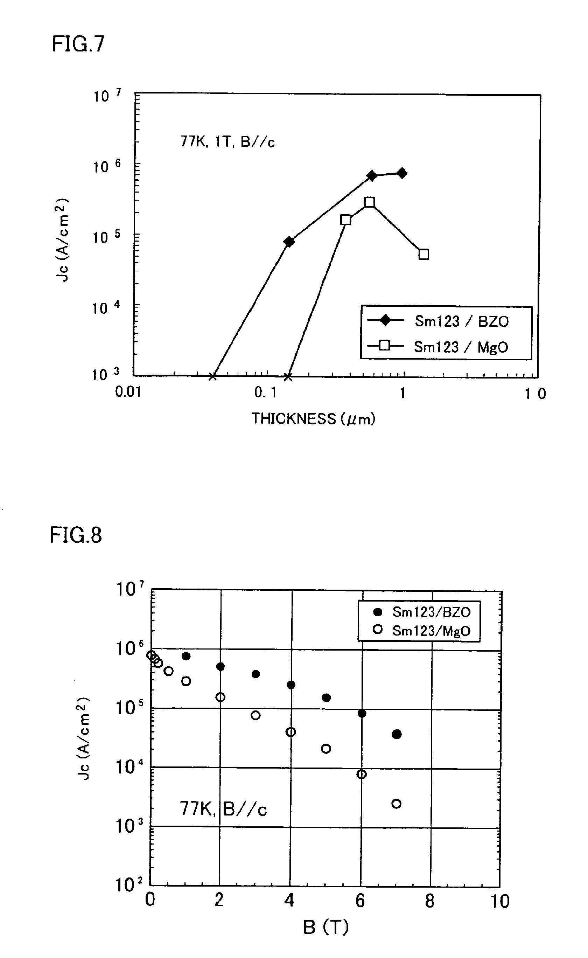

Fig. 7 shows the relation between the thickness of Sm123 film and the critical current density. In this graph, a horizontal axis represents the thickness (μm) of the Sm123 film, and a vertical axis represents the critical current density Jc ($A/cm^2$). It is noted that the critical current density Jc was measured in a state where magnetic field B of 1 T was applied parallel to the c axis of the Sm123 film at a temperature of 77 K. In the graph, a mark ♦ corresponds to the Sm123 film on the BZO underlayer, while a mark □ corresponds to the Sm123 film on the MgO underlayer. A mark X means that the current value does not reach $10^3$ A/cm$^2$ in the transition region from the normal conducting state to the superconducting state of zero resistance.

As seen from Fig. 7, when the Sm123 film on the BZO underlayer is as thin as 0.1 μm, its Jc is considerably improved compared to that of the Sm123 film on the MgO underlayer. In the case of Sm123/MgO, although Jc increases to some extent with increase of the film thickness, thereafter it begins to decrease. In the case of Sm123/BZO, on the other hand, Jc increases with increase of the film thickness, and it maintains high Jc up to the film thickness of about 1 μm. It is thus found that the differences in the interface structures as well as the crystal structures in the vicinity of the interfaces significantly affect the film properties when the film thicknesses are increased, which is presumably for the following reasons.

In the case of Sm123/MgO which suffers considerable disturbance in crystal orientation in the vicinity of the interface, i.e., in initial growth of the thin film on the underlayer, as schematically shown in Fig. 4, lattice mismatch between the crystal grains at the time of their coalescence causes strain which remains in the thin film. Since the energy of strain is accumulated with increase of film thickness, surface irregularity occurs from the flat surface of the thin film so as to relax the strain, and crystals of different orientations grow on the irregular surface, so that crystallinity of the thin film is degraded with increase of the film thickness exceeding about 1 μm. In the case of Sm123/BZO, on the other hand, since the strain energy within the thin film is small as seen from Fig. 3, the crystal growth is possible with the flat surface and orientation being maintained even if the film thickness is increased.

Fig. 8 shows the dependence of critical current density Jc of the Sm123 films on the external magnetic field. In this graph, a horizontal axis represents the magnetic field B (T) externally applied, and a vertical axis represents the critical current density Jc (A/cm$^2$). It is noted that Jc was measured in a state where the magnetic field B was applied parallel to the c axis of the Sm123 film at a temperature of 77 K. A mark • and a mark o represent the Sm 123 films on the BZO underlayer and on the MgO underlayer, respectively.

As seen from Fig. 8, Sm123/BZO maintains Jc higher than that of Sm123/MgO with the higher magnetic field applied. It is generally said that a thin film of high-temperature superconductor shows its high Jc property compared to that in a bulk state, though its Tc is slightly low compared to that in the bulk state. According to the present invention, however, it is shown that the single crystalline thin film having the structure controlled from the interface between the objective film and its underlayer can realize a high Tc similar to that of the bulk state and a high Jc-B property equal or superior to that of the bulk state.

Further, it has been found in the present invention that the interface energy even in a complicated substance system can be quantified by using the first-principles calculation band method as a calculation method of the interface energy. It was found that the calculated result of the interface energy agreed well with the result of the above-described example. It was also found that, at the interface, each atom in the crystal structure of single substance suffers displacement from its ideal site and then the degree of this displacement was correlated with the magnitude of the interface energy. This is not only able to explain the experimental results for the substance system of Sm123/BZO/MgO, but also means that, in the case of setting an unknown interface in the future, the interface energy can be calculated to allow selection of preferable candidate substances for the intermediate layer in advance. At the time of designing a stacked-layer structure including a plurality of substances, therefore, the present invention can provide highly effective means for obtaining a stacked-layer structure of a good quality.

<Calculation of interface energy by first-principles calculation>

(First-principles calculation band method)

The method employed is called a band calculation method of the first-principles calculation that is suitable for handling problems of solid substances. The method has the following features of (a) through (d) (for detailed explanation of this method, see the text for The 2001 Seminar of Japan Institute of Metals, titled "Material Engineering for Studying with Personal Computer", pp. 21-31).

(a) Information necessary for the calculation method includes atomic numbers and initial atomic sites (crystal structure), while experimental values and empirical parameters are not needed.
(b) In the process of calculation, positional variations of constituent atoms, electron states, and energies are calculated repeatedly to optimize the structure such that the system energy is minimized.
(c) The obtainable results can include an atomic arrangement, a lattice constant, a formation enthalpy, an interface structure, an interface energy, an electron state and others.
(d) Limitations imposed on the calculation method include the absolute zero point, a periodic boundary condition, and the number of atoms up to about 100 within a unit cell.

If desired, validity of the calculated results can be checked by comparing the calculated values and the experimental values available. In the course of making the present invention, calculation was carried out regarding a perfect crystal of each single substance prior to attending to the problems of the interface, and the calculated results were compared with the experimental values. For each of Sm123, BZO and MgO, the calculated result of lattice constant agreed with the experimental value with a difference within about 1%. Further, in Sm123 having a complicated crystal structure, the calculated atomic arrangement (positional coordinates of each atom in the unit cell in which each of Ba and Cu constitutes the same atomic layer with O but is not in the same plane with O) agreed with the experimental value with a difference within about 2% (see Jpn. J. Appl. Phys., Vol. 34, 1995, pp. 6031-6035). As described above, it is possible to obtain calculated results for a perfect crystal of a single substance. Description will now be given for handling of a system including an interface.

(Setting of interface model)

To carry out calculations for an interface of interest, firstly, it is necessary to make a model of atomic structure of the interface. Although a fundamental unit cell of crystal structure may be employed for a perfect crystal of a single substance, in the case of an interface, an expanded cell (super cell) is constructed from the fundamental unit cell. At this time, there is the above-described limitations (d) of the periodic boundary condition and the number of atoms up to about 100 within the unit cell (within capability of the computer used in the analysis). Therefore, it was necessary to consider the following measures.

Specifically, since Sm123 has a lattice constant difference of about 8% at the interface with each of MgO and BZO, the lattice constant of Sm123 was adjusted to that of MgO or BZO (more specifically, the a-axis length of the Sm123 lattice was extended by about 8% for optimization of the structure). This makes it possible to impose the periodic boundary condition with the same number of atoms as that in the unit cell of the single substance in directions parallel to the interface. In a direction perpendicular to the interface, a structure including two interfaces symmetrical to each other in upper and lower directions was employed to reduce the time required for calculation. In this structure, the single substance layer at the center was made to have a thickness corresponding to several atomic layers so as to reduce interaction between the two interfaces. As such, the number of atoms in the cell was restricted within about 100.

If the lattice constants of respective substances are used without the modification, 12-13 unit cells are needed to make the lattices of the substances have a common period in the directions parallel to the interface, according to estimation from the lattice constant difference. In such a case, the number of atoms in the super cell increases to about 150 times corresponding to the square of the enlarged period, which makes it necessary to use an extremely large computer and makes the calculation impractical. As described above, since the lattice constants of the substances are matched at the interface in the process of calculation, the calculation can substantially be regarded as computation of the chemical factor of the interface energy of the Sm123/BZO/MgO substance system. In other words, by considering the geometrical factor and the chemical factor separately in the interface energy, it is possible to carry out analysis of the system having the large lattice constant difference between the substances.

Atomic plane structures at the termination planes of substances forming the interface are critical for the interface energy. The unit cell of Sm123 is formed of six atomic layers, which means that there are six possible atomic layers coming into contact with MgO. It may be possible to carry out calculations for all the possible layers. However, in view of a report on cross-sectional TEM (transmission electron microscopy) observation of a similar system of Y123/MgO interface having the BaO plane as the termination plane on the Y123 side (see The Fourth Pacific Rim International Conference on Advanced Materials and Processing, 2001, pp. 729-732, The Japan Institute of Metals), the present embodiment adopted the lattice structures having the stacking sequences as follows (a mark + means an interface having been set):

for Sm123/MgO: bulk (MgO) - MgO plane + BaO plane - CuO plane - BaO plane - bulk (Sm123); and
for Sm123/BZO: bulk (BZO) - $ZrO_2$ plane + BaO plane - CuO plane - BaO plane - bulk (Sm123).

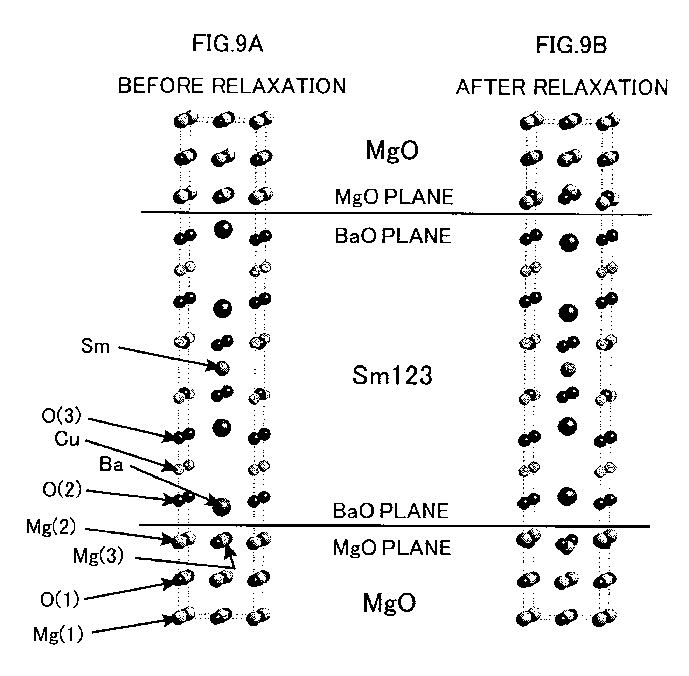

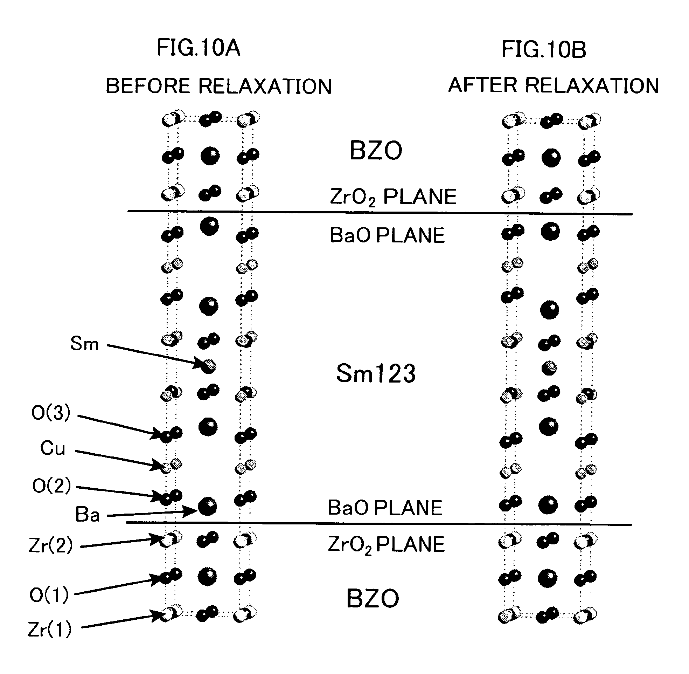

While RE123 includes two different BaO planes in its stacked-layer structure, the one which the CuO chain plane resides immediately on the BaO was adopted as the interface in the present embodiment. Further, it was considered that, by selecting the $ZrO_2$ plane as the termination plane on the BZO side at the interface of Sm123/BZO, it would be possible to comparatively evaluate the interface energies when only the substratum under Sm123 was changed from MgO to BZO or vice versa. The atomic arrangement of the BaO plane as the termination plane on the Sm123 side was shifted by a half of the lattice constant in the interface, to calculate both the case of Ba residing immediately on Mg (referred to as "Ba on Mg") and the case of Ba on O (referred to as "Ba on O"). It was supposed at the interface of Sm123/BZO that Ba in the termination plane of Sm123 is on the same axis as Ba in BZO of the underlayer (referred to as "Ba in BZO"). An interval between the atomic planes (half the lattice constant: about 0.21 nm) of MgO or BZO was used as the initial value for the spacing at the interface. The super cells including the interfaces thus formed are shown in Figs. 9A and 10A. Fig. 9A shows the interface of Sm123/MgO (with Ba on Mg), and Fig. 10A shows the interface of Sm123/BZO.

(Introduction of necessary formula)

The interface energy is defined as "excessive energy due to presence of an interface" in the thermodynamics. When the interface is regarded as a kind of lattice defect, the interface energy can be expressed by the following general expression (1) related to formation energy Ef of the defect:

$$Ef = Ed - Ep \qquad (1)$$

where Ed represents energy of the crystal including the defect, and Ep represents energy of a perfect crystal. A cell (super cell) obtained by expanding the fundamental unit cell is used for calculation of Ed. In the case of the interface between different kinds of compounds as in the present embodiment, information of chemical potential $\mu$ is required for calculation of the interface energy, as described in the following.

In the case of a pure substance, when the number of constituent atoms is represented as n, the following expression holds:

$$Ep = \mu n \qquad (2)$$

By calculating Ep, p can be obtained as energy per atom. In the case of a compound, on the other hand, when chemical potential for a component i is represented as $\mu_i$ and the number of atoms is represented as $n_i$, the following expression holds:

$$Ep = \Sigma \mu_i n_i \qquad (3)$$

in which case $\mu_i$ is a variable dependent on the composition element.

In the calculation model of the present embodiment, expression (1) can be expanded in the case of Sm123/MgO interface, as follows:

$$Ef = 1/2 \{Ed - \Sigma \mu_i n_i\} \qquad (4)$$

$$= 1/2 \{E_{SmBa4Cu4Mg10O18} - (\mu_{Sm} + 4\mu_{Ba} + 4\mu_{Cu} + 10\mu_{Mg} + 18\mu_O)\} \qquad (5)$$

$$= 1/2 \{E_{SmBa4Cu4Mg10O18} - E_{SmBa2Cu3O6} - 10E_{MgO} - (\mu_{Cu} + 2\mu_{Ba} + 2\mu_O)\} \qquad (6)$$

In the above expressions (4)-(6), coefficient 1/2 is multiplied since the super cell includes two interfaces.

Expression (5) utilizes the relation in which elements of the same kind existent in a plurality of phases under a thermal equilibrium state have the same chemical potential, which can be expressed as:

$$\mu_O = \mu_O \text{ in Sm123} = \mu_O \text{ in MgO} \qquad (7)$$

Further, the expression (6) is rearranged using the relations of the following expressions (8) and (9):

$$\mu_{Sm} + 2\mu_{Ba} + 3\mu_{Cu} + 6\mu_O = \mu_{SmBa2Cu3O6} = E_{SmBa2Cu3O6} \qquad (8)$$

$$\mu_{Mg} + \mu_O = \mu_{MgO} = 1 0E_{MgO} \qquad (9)$$

In the expression (6), although the first, second and third terms can be obtained with the first-principles band calculation method, there remain unknown values for the chemical potentials in the fourth term. Even if the number of layers of Sm 123 is increased in the super cell, the fourth term always remains as the excessive energy at the interface, which is an important factor for calculation of the interface energy. To obtain ranges of $\mu_{Cu}$, $\mu_{Ba}$ and $\mu_{O}$, it is also necessary to consider the thermal equilibrium conditions as follows (for example, an expression (12) corresponds to a condition that there is no precipitation of BaO):

$$\mu_{Cu} + \mu_{O} < \mu_{CuO} \qquad (10)$$

$$2\mu_{Cu} + \mu_{O} < \mu_{Cu2O} \qquad (11)$$

$$\mu_{Ba} + \mu_{O} < \mu_{BaO} \qquad (12)$$

In the present embodiment, as a first stage, the sign "<" in each of expressions (10), (11) and (12) is approximated to a sign "=". This corresponds to a condition in which precipitates of CuO, $Cu_2O$ and BaO can coexist, which is hereinafter referred to as a "BaO co-precipitation condition".

Similarly, for the Sm123/BZO interface, expression (1) can be rearranged as follows:

$$Ef = 1/2 \{E_{SmBa6Cu4Zr3O16} - E_{SmBa2Cu3O6} - 3E_{BaZrO3} - (\mu_{Cu} + \mu_{Ba} + \mu_{O})\} \qquad (13)$$

Here, again, the chemical potentials of Ba, Cu and O remain unknown, and thus approximation was done with the BaO co-precipitation condition similarly as in the case of the Sm123/MgO interface.

(Calculated results)

Among the results of calculation, the interface energy values are shown in Table 1. As seen from Table 1, the interface energy of Sm123/BZO is 0.79 J/m$^2$, which is about 1/3 of that of Sm123/MgO, causing a considerable difference therebetween.

Table 1:

| Results of Calculation of Interface Energy (BaO Co-precipitation Condition) | | |
|---|---|---|
| Constitution of interface | Atomic arrangement at interface | Interface energy (J/m$^2$) |
| Sm123/MgO | Ba on Mg | 2.25 |
| Sm123/MgO | Ba on O | 2.74 |
| Sm123/BZO | Ba in BZO | 0.79 |
| BZO/MgO | Zr on O | 1.12 |

Figs. 9B and 10B show states after relaxation of the atomic structures at the Sm123/MgO interface (Ba on Mg) and the Sm123/BZO interface, respectively, optimized by the first-principles calculation. As seen from comparison between the atomic structures at the interface before and after relaxation, in the case of Sm123/MgO, ions of the same sign ($Mg^{2+}$ within MgO and $Ba^{2+}$ within Sm123) considerably relax so as to avoid being too close to each other at the interface (i.e., great strain is caused at the interface compared to the original perfect crystal).

By comparison, in the case of Sm123/BZO, relaxation occurs such that Ba and O on the BaO plane at the interface are approximately in the same plane, and the interval between the atomic planes at the interface after the relaxation is close to that of the perfect crystal of BZO. That is, in the stable structure obtained after setting the initial atomic sites, the Ba layer at the termination plane of Sm123 becomes almost equivalent to the BaO layer in BZO, and it is neatly aligned with the $ZrO_2$ plane as if it were the BaO plane of BZO. In other words, it can be considered that Sm123 and BZO share the BaO layer at their interface.

Displacement of an atomic site in the vicinity of the interface was defined by the following expression (14) on the basis of the atomic site in the perfect crystal, to numerically express the degree of strain from the perfect crystal:

$$\text{Displacement from atomic site in perfect crystal (\%)} = \{(\text{distance between atoms}$$

$$\text{after relaxation - distance between atoms before relaxation) / distance between atoms}$$

$$\text{before relaxation}\} \times 100 \tag{14}$$

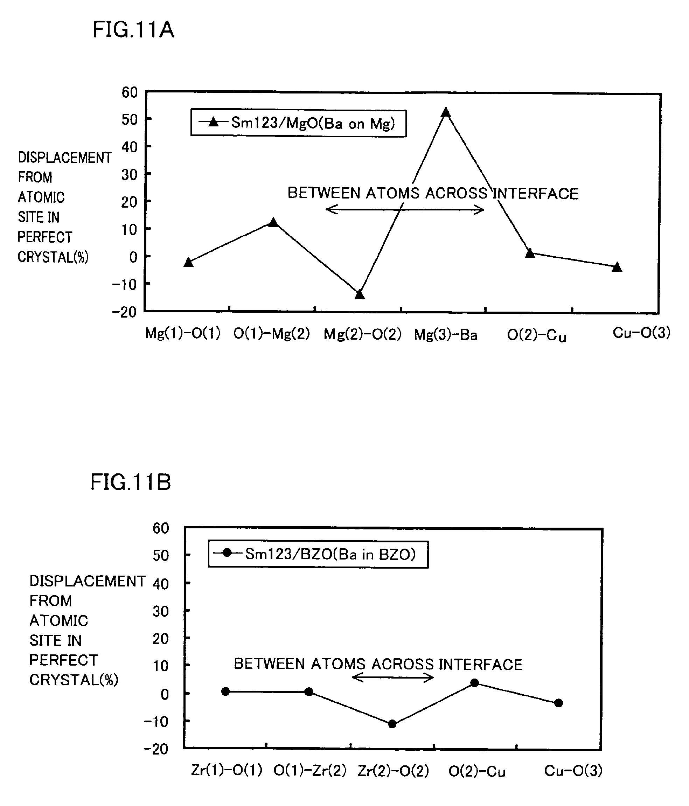

Figs. 11A and 11B are graphs showing the degrees of strain at the interfaces of Sm123/MgO and Sm123/BZO, respectively. In each graph, a horizontal axis represents the pairs of atoms shown with arrows in Figs. 9A, 9B, 10A and 10B, and a vertical axis represents their displacement. While the displacement in the vicinity of the interface of Sm123/MgO is large in a range from -13% to 53%, the displacement at the interface of Sm123/BZO is small in a range from -11% to 4.1%. In the case of the Sm123/BZO interface, if the position of the BaO layer at the interface is defined on the basis of the perfect crystal of BZO, the displacement becomes smaller in a range from -0.7% to 4.1 %, clearly showing that there is less disturbance in the atomic structure at the interface of Sm123/BZO. It is confirmed that another Sm123/MgO interface (with Ba on O) also shows considerable disturbance of the atomic structure in the interface structure. As such, the low interface energy of Sm123/BZO also corresponds to the fact that there is less disturbance in the atomic structures at the interface depicted by the first-principles calculation.

On the contrary, the calculated results for the Sm123/MgO interface show that the chemical factor of the interface energy remains large with the combination of these substances, even if their actual lattice constants match. In other words, even if a substance matching in lattice constant with the objective thin film is selected for the substrate or the intermediate layer, the interface energy with respect to the thin film does not always decrease. Selection of the substance for the underlayer taking only account of the lattice constant cannot guarantee a stable structure at the interface. Therefore, it is important to consider the selecting method of the substance for the intermediate layer as explained in the present invention.

Similarly as the above, the interface energy can be calculated for a BZO/MgO interface, too. A model of the relevant interface and calculated results of the interface energy are now described in brief. From the crystal structures of the respective substances, the stacking sequence of layers was set as follows:

$$\text{for BZO/MgO: bulk (MgO) - MgO plane + ZrO}_2 \text{ plane - bulk (BZO),}$$

and the atomic arrangement in the interface was set such that Zr in BZO resides immediately on O in MgO (Zr on O). The calculated result of the interface energy was as small as 1.12 J/m$^2$, which is also shown in Table 1. It is also confirmed in an optimal structure derived from the interface model that there is only small displacements from ideal atomic sites in the perfect crystal of the single substance.

As described above, it has been shown that it is possible by using the first-principles calculation to calculate the interface energy which has been considered as a factor for improving epitaxy of the Sm123 film on the MgO base substance by the BZO intermediate layer interposed therebetween, and it has been found that the calculated results agree with the experimental results shown in the above-described article of J. Japan Inst. Metals, Vol. 66 (2002), pp. 320-328.

It is noted that, since the above-described high-resolution TEM observation and the first-principles calculation were concurrently carried out with respect to the interface, although the TEM observation result and the Sm123/BZO interface models used for the first-principles calculation were similar in point of sharing the BaO plane, there was some difference therebetween in stacking sequence of the atomic layers. For example, however, when the Ba plane and the Cu chain plane on the Sm123 side are taken out from the interfaces shown in Figs. 10A and 10B, an interface model corresponding to the TEM observation result is formed whereby making it possible to calculate the interface energy in a similar manner as described above, though the Sm123 layer is reduced in thickness.

<Summary and Development>

The interface energies were quantified for the interfaces of different kinds of complicated compounds of Sm123/MgO and Sm123/BZO. When the factor of excessive chemical potential at the interface was approximately calculated on the BaO co-precipitation condition, the interface energy of Sm123/BZO was 0.79 J/m$^2$, and the interface energy of BZO/MgO was 1.12 J/m$^2$, which were sufficiently smaller than the interface energy of Sm123/MgO of 2.25 J/m$^2$ or 2.74 J/m$^2$.

These calculated results agree with the experimental results indicating that the selection of BZO as a substance for the intermediate layer on the MgO substrate can improve epitaxy of Sm123. As such, supposing a stacked-layer structure including an intermediate layer with consideration of atomic layers, when calculations are carried out for an interface energy Ea between the intermediate layer and the base substance, an interface energy Eb between the objective thin film and the intermediate layer, and an interface energy Ec between the thin film and the base substance in the stacked-layer structure from which the intermediate layer has been taken out, it can be determined that the intermediate layer satisfying both Ea < Ec and Eb < Ec matches both the thin film and the base substance.

BZO selected herein as a substance for the intermediate layer can reduce the interface energies with both the base substance MgO and the thin film Sm123. The $ZrO_2$ layer in BZO plays an important role for MgO, while the BaO layer in BZO plays an important role for Sm123. In general, therefore, paying attention to compounds each of which include at least two kinds of atomic layers, it is preferable to calculate the interface energies with respect to intermediate layers each of which includes an atomic layer assumed to reduce the interface energy with both the objective thin film and the base substance.

The inventors had expected from their crystallographic consideration that BZO having the perovskite type structure and MgO having the rock-salt type structure would be able to form a continuous interface structure. In the present embodiment, it has become possible to quantify the smallness of the interface energy of such an interface structure. As a way of reducing the interface energy, therefore, when the oxide is considered as a coordination polyhedron centered with a metal ion, it is preferable to use a combination of oxide substances permitting linkage of oxygen atoms at the apexes of the coordination polyhedrons across the interface.

As a development of the present embodiment, with respect to the factor of excessive chemical potential approximated at the interface, it is possible to carry out calculations for other various compounds able to coexist as precipitates, in order to narrow the range of the possible chemical potential for each atom and increase the degree of precision in the value of the interface energy.

In the present embodiment, the lattice constants have been matched in the process of calculation of the interface energy. Although the calculation of the interface energy is still insufficient in terms of the geometrical factor of the interface energy associated with lattice mismatch or in terms of the total interface energy including the geometrical factor, application of the contents provided in the present embodiment will make it possible to calculate the total interface energy in the following manner, for example. It is considered that the in-plane geometrical arrangement at an actual interface is gradually deviated due to the difference in lattice constant. In the present embodiment, for the interface of Sm123/MgO, calculations were carried out regarding the two cases with the atomic arrangement in the interface shifted by half the unit cell from each other. Similarly, a plurality of interface models can be set for representative cases with the atomic arrangement in the interface shifted from each other, and the calculated results of the interface energy can be averaged depending on their expected frequency.

In the present embodiment, the interface energy has been obtained using only the first-principles calculation band method. However, thermodynamic data may be incorporated as desired in the calculating process of the first-principles calculation band method, if they are applicable to the calculation of the interface energy. Besides the first-principles calculation band method, a calculation method empirically supposing potentials, for example, may be employed for making calculations for a super cell including a larger number of atoms.

Industrial Applicability

As described above, according to the present invention, when a thin film of a substance is formed on an underlayer, formation of a single crystalline thin film of a better quality is ensured to provide a thin film having properties equal or superior to those of the same substance of a bulky state.

**Claims**

1. A single crystalline thin film formed on an underlayer, wherein
   said thin film is made of a substance different from that of said underlayer,
   a specific atomic layer contained in common in said underlayer and said thin film is shared at an interface of said underlayer and said thin film, and
   in a region as adjacent to the interface as 100 or fewer unit cells of the thin film apart from the interface, a ratio of crystalline regions having grown with an orientation of $\pm$ 2 degrees or less deviation angle on the basis of a crystal orientation of said underlayer is 50% or more.

2. The single crystalline thin film according to claim 1, wherein each of said thin film and said underlayer is made of a substance having a stacked-layer crystal structure.

3. The single crystalline thin film according to claim 1, wherein at least one of said thin film and said underlayer is made of an oxide including at least two kinds of metal elements.

4. The single crystalline thin film according to claim 1, wherein at least one of said thin film and said underlayer is made of a substance having a crystal structure of a perovskite type.

5. The single crystalline thin film according to claim 1, wherein a difference in lattice constant between said thin film and said underlayer is in a range of more than 5% and less than 15%.

6. The single crystalline thin film according to claim 1, wherein said thin film is made of a $RE_{1+x}Ba_{2-x}Cu_3O_{7-y}$ based superconductor, where RE represents at least one kind of rare earth elements.

7. The single crystalline thin film according to claim 1, wherein said underlayer is made of $BaZrO_3$.

8. The single crystalline thin film according to claim 1, wherein said thin film shows superconductivity at a temperature higher than 91 K.

9. The single crystalline thin film according to claim 1, wherein said interface has its interface energy of lower than 2 $J/m^2$.

10. The single crystalline thin film according to claim 9, wherein said interface energy is calculated by the first-principles calculation band method.

## FIG.1

## FIG.2

FIG.3

Sm123/BZO

$V_{epi} / V \sim 80\%$

FIG.4

Sm123/MgO

$V_{epi} / V \sim 30\%$

FIG.5

FIG.6

FIG.7

77K, 1T, B//c

Jc (A/cm²)

THICKNESS (μm)

◆ Sm123 / BZO
☐ Sm123 / MgO

FIG.8

● Sm123/BZO
○ Sm123/MgO

Jc (A/cm²)

77K, B//c

B (T)

FIG.9A

BEFORE RELAXATION

FIG.9B

AFTER RELAXATION

MgO

MgO PLANE

BaO PLANE

Sm

Sm123

O(3)

Cu

Ba

O(2)

BaO PLANE

Mg(2)

MgO PLANE

Mg(3)

O(1)

MgO

Mg(1)

FIG.10A
BEFORE RELAXATION

FIG.10B
AFTER RELAXATION

BZO

$ZrO_2$ PLANE

BaO PLANE

Sm123

Sm

O(3)

Cu

O(2)

Ba

BaO PLANE

Zr(2)

$ZrO_2$ PLANE

O(1)

BZO

Zr(1)

## FIG.11A

## FIG.11B

<table>
<tr><td colspan="2" style="text-align:center">**INTERNATIONAL SEARCH REPORT**</td><td>International application No.<br>PCT/JP03/13888</td></tr>
</table>

**A. CLASSIFICATION OF SUBJECT MATTER**
Int.Cl$^7$ C30B29/22, H01L39/24

According to International Patent Classification (IPC) or to both national classification and IPC

**B. FIELDS SEARCHED**

Minimum documentation searched (classification system followed by classification symbols)
Int.Cl$^7$ C30B29/22, H01L39/24

Documentation searched other than minimum documentation to the extent that such documents are included in the fields searched

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)
WPI, JSTPlus(JOIS)

**C. DOCUMENTS CONSIDERED TO BE RELEVANT**

| Category* | Citation of document, with indication, where appropriate, of the relevant passages | Relevant to claim No. |
|---|---|---|
| X | Katsuya HASEGAWA et al., "Laser Jochakuho ni yoru SmBa$_2$Cu$_3$O$_y$ Maku no Sakusei to Sono Mennai Haikosei Kojo", Nippon Kinzoku Gakkaishi, 20 April, 2002 (20.04.02), Vol.66, No.4, pages 320 to 328; Page 326, left column, line 23 to page 327, right column, line 34 | 1-10 |
| A | US 5607899 A (SUMITOMO ELECTRIC INDUSTRIES LTD.), 04 March, 1997 (04.03.97), & JP 7-291626 A & EP 669411 A2 | 1-10 |

☐ Further documents are listed in the continuation of Box C.    ☐ See patent family annex.

| | |
|---|---|
| * Special categories of cited documents:<br>"A" document defining the general state of the art which is not considered to be of particular relevance<br>"E" earlier document but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>07 January, 2004 (07.01.04) | Date of mailing of the international search report<br>27 January, 2004 (27.01.04) |
|---|---|
| Name and mailing address of the ISA/<br>Japanese Patent Office | Authorized officer |
| Facsimile No. | Telephone No. |

Form PCT/ISA/210 (second sheet) (July 1998)